# DEMANDE DE BREVET EUROPEEN

(11) **EP 4 712 759 A1**
(43) Date de publication de la demande: **18.03.2026**
(21) Numéro de dépôt: 25199568.4
(22) Date de dépôt: 02.09.2025
(51) Int. Cl.: H10W 72/00, H10W 72/20, H10W 72/29

(54) **PROCEDE D'ASSEMBLAGE D'UN COMPOSANT ELECTROACOUSTIQUE A UN CIRCUIT ELECTRONIQUE PAR SOUDURE PAR REFUSION**

(30) Priorité: 11.09.2024 FR 2409639
(71) Demandeur: VERMON SA, 37000 Tours (FR)
(72) Inventeur: PORCHER, Nicolas, 37000 TOURS (FR); COLAS, Quorentin, 37000 TOURS (FR)
(74) Mandataire: Cabinet Beaumont

(57) **Abrégé**

La présente description concerne un procédé de fabrication d'un dispositif ultrasonore (100) comprenant un circuit électronique (60) et un composant électroacoustique (25), le procédé comprenant la formation de premiers plots de connexion (40) fixés à une plaque comprenant un exemplaire ou des exemplaires du composant électroacoustique (25), la formation de billes de soudure (46) sur les premiers plots (40), la fusion des billes de soudure (46) pour qu'elles adhèrent aux premiers plots (40), éventuellement la découpe de la plaque pour séparer les composants électroacoustiques (25), la formation de deuxièmes plots de connexion (80) fixés au circuit électronique (60), l'application du composant électroacoustique (25) sur le circuit électronique (60) pour que les billes de soudure (46) viennent au contact des deuxièmes plots (80), et la fusion des billes de soudure (46) pour qu'elles adhèrent aux premiers plots (40) et aux deuxièmes plots (80).

## Description

### Domaine technique

La présente description concerne de façon générale un procédé d'assemblage d'un composant électroacoustique à un circuit électronique par soudure par refusion.

### Technique antérieure

Un procédé d'assemblage d'un premier circuit électronique et d'un deuxième circuit électronique par soudure par refusion comprend la formation de premières soudures entre le premier circuit électronique et des billes de soudure en un alliage métallique brasable, puis la formation de deuxièmes soudures entre les billes de soudure et le deuxième circuit électronique.

Pour certaines applications, il existe un besoin d'assembler un composant électroacoustique à un circuit électronique par soudure par refusion.

### Résumé de l'invention

Un mode de réalisation pallie tout ou partie des inconvénients des procédés d'assemblage d'un composant électroacoustique à un circuit électronique par soudure par refusion connus.

Un mode de réalisation prévoit un procédé de fabrication d'un dispositif ultrasonore comprenant un circuit électronique et un composant électroacoustique, le procédé comprenant les étapes suivantes :
- former des premiers plots de connexion fixés à une plaque comprenant un exemplaire ou des exemplaires du composant électroacoustique ;
- former des billes de soudure sur les premiers plots de connexion ;
- faire fondre les billes de soudure pour qu'elles adhèrent aux premiers plots de connexion ;
- éventuellement découper la plaque pour séparer les composants électroacoustiques ;
- former des deuxièmes plots de connexion fixés au circuit électronique ;
- appliquer le composant électroacoustique sur le circuit électronique pour que les billes de soudure viennent au contact des deuxièmes plots de connexion ; et
- refaire fondre les billes de soudure pour qu'elles adhèrent aux premiers plots de connexion et aux deuxièmes plots de connexion.

Selon un mode de réalisation, chaque premier plot de connexion comprend un empilement d'une couche d'accroche, d'une couche métallique et d'une couche de finition, la couche métallique étant interposée entre la couche d'accroche et la couche de finition, la couche d'accroche étant au contact physique direct du composant électroacoustique et de la couche métallique, et la couche de finition étant au contact physique direct de la couche métallique.

Selon un mode de réalisation, la couche d'accroche est en chrome ou en alliage de chrome.

Selon un mode de réalisation, la couche métallique est en cuivre.

Selon un mode de réalisation, la couche de finition est en or.

Selon un mode de réalisation, le composant électroacoustique comprend un revêtement en carbure de tungstène, les premiers plots de connexion étant en contact physique direct avec le revêtement.

Selon un mode de réalisation, la plaque comprend une face sur laquelle reposent les premiers plots de connexion, le procédé comprenant la formation du revêtement en carbure de tungstène sur l'ensemble de la face et le retrait des portions du revêtement en carbure de tungstène sur la face entre les plots de connexion.

Selon un mode de réalisation, le circuit électronique est un circuit intégré propre à une application ou un circuit imprimé.

Un mode de réalisation prévoit également un dispositif ultrasonore comprenant :
- un composant électroacoustique ;
- des premiers plots de connexion fixés au composant électroacoustique ;
- un circuit électronique ;
- des deuxièmes plots de connexion fixés au circuit électronique ; et
- des billes de soudure fixées aux premiers plots de connexion par des premières liaisons issues de deux fusions des billes de soudure et des premiers plots de connexion et fixées aux deuxièmes plots de connexion par des deuxièmes liaisons issues d'une unique fusion des deuxièmes plots de connexion.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, la figure 2, la figure 3, la figure 4, la figure 5, la figure 6, et la figure 7 sont des vues en coupe, partielles et schématiques, des structures obtenues à des étapes successives d'un mode de réalisation d'un procédé de fabrication d'un dispositif électronique relatives à la fabrication de plots de connexion sur un composant électroacoustique du dispositif électronique ;
la figure 8 est une vue en perspective, partielle et schématique, du composant électroacoustique de la figure 7 ;
la figure 9, la figure 10, la figure 11, et la figure 12 sont des vues en coupe, partielles et schématiques, des structures obtenues à des étapes successives d'un mode de réalisation d'un procédé de fabrication d'un dispositif électronique relatives à la fabrication de plots de connexion sur un circuit électronique du dispositif électronique ;
la figure 13 est une vue en perspective, partielle et schématique, du circuit électronique de la figure 12 ;
la figure 14 et la figure 15 sont des vues en coupe, partielles et schématiques, des structures obtenues à des étapes successives d'un mode de réalisation d'un procédé de fabrication d'un dispositif électronique relatives à la fixation du composant électroacoustique sur le circuit électronique ;
La figure 16 est une vue en perspective, partielle et schématique, du dispositif ultrasonore représenté en figure 15 ;
la figure 17 est une vue en coupe, partielle et schématique, de la structure obtenue à une étape ultérieure d'un mode de réalisation d'un procédé de fabrication d'un dispositif électronique ; et
la figure 18 est photographie d'une coupe du dispositif ultrasonore montrant un UBM du circuit électroacoustique, un UBM du circuit électronique, et une bille de soudure soudée aux deux UBMs.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments. En outre, on considère ici que les termes "isolant" et "conducteur" signifient respectivement "isolant électriquement" et "conducteur électriquement".

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures dans une position normale d'utilisation.

Sauf précision contraire, les expressions "environ", "approximativement", "sensiblement", et "de l'ordre de" signifient à 10 % ou à 10° près, de préférence à 5 % ou à 5° près.

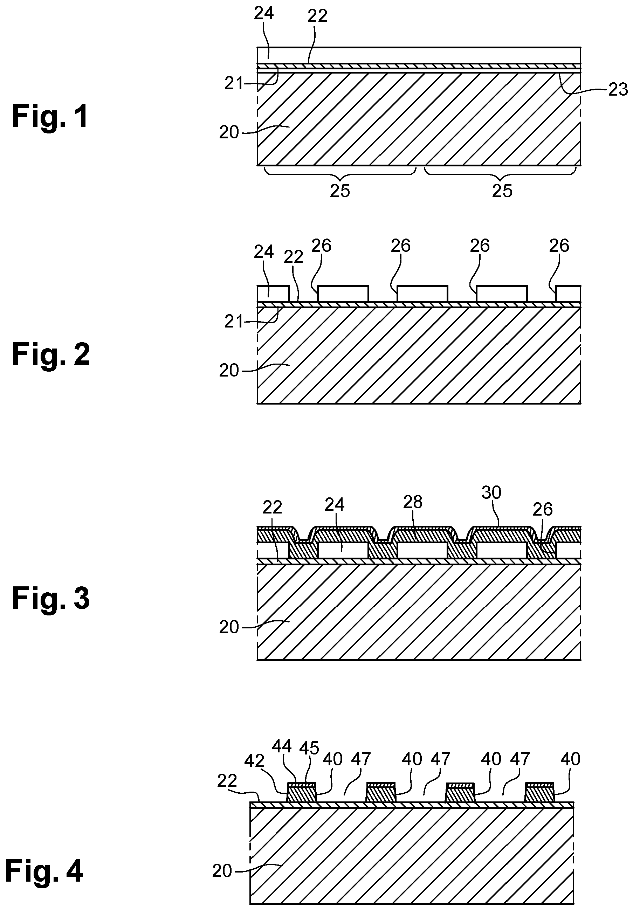

La figure 1, la figure 2, la figure 3, la figure 4, la figure 5, la figure 6, et la figure 7 sont des vues en coupe, partielles et schématiques, des structures obtenues à des étapes successives d'un mode de réalisation d'un procédé de fabrication d'un dispositif électronique relatives à la fabrication de plots de connexion, également appelés UBMs (sigle anglais pour Under Bump Metallisation), sur un composant électroacoustique du dispositif électronique.

La figure 1 représente la structure obtenue après une étape de formation d'une couche d'accroche 22 sur la face supérieure 21 d'une plaque 20, et le dépôt d'une couche de résine photosensible 24 sur la couche d'accroche 22 Selon un mode de réalisation, l'épaisseur de la couche de résine 24 est supérieure ou égale à 12 µm.

Selon un mode de réalisation, la plaque 20 comprend plusieurs exemplaires d'un composant électroacoustique 25, deux exemplaires étant représentés à titre d'exemple en figure 1. Selon un mode de réalisation, la plaque 20 comprend un revêtement 23 du côté de la face supérieure 21 et la couche d'accroche 22 est déposée sur le revêtement 23. Le revêtement 23 n'est représenté à titre d'exemple que sur la figure 1. Selon un mode de réalisation, le revêtement 23 forme un miroir acoustique lors du fonctionnement du composant électroacoustique 25. Selon un mode de réalisation, le revêtement 23 est en carbure de tungstène (WC). Selon un mode de réalisation, l'épaisseur du revêtement 23 correspond typiquement à environ la moitié de la longueur d'onde centrale de l'onde acoustique. Selon un mode de réalisation, la face supérieure 21 a une finition dite poli miroir, ce qui signifie que la rugosité arithmétique Ra de la face supérieure 21 est inférieure à 300 nm. Selon un mode de réalisation, la couche d'accroche 22 est en chrome ou en alliage de chrome. Selon un mode de réalisation, l'épaisseur de la couche d'accroche 22 est comprise entre 10 nm et 500 nm, et est par exemple égale à environ 40 nm.

Selon un mode de réalisation, la couche d'accroche 22 est formée par un dépôt physique en phase vapeur (PVD, sigle anglais pour Physical Vapor Deposition). Selon un autre mode de réalisation, la couche d'accroche 22 est formée par galvanoplastie (en anglais electroplating). Selon un mode de réalisation, la formation de la couche d'accroche 22 est précédé d'une étape de nettoyage de la face 21, par exemple une étape de décapage ionique de la face 21. L'étape de décapage ionique comprend un bombardement ionique de la face 21, par exemple par des ions azote.

La figure 2 représente la structure obtenue après une étape de formation d'ouvertures 26 dans la couche de résine 24 aux emplacement souhaités des UBMs, quatre ouvertures 26 étant représentées à titre d'exemple en figure 2. La formation des ouvertures 26 peut comprendre des étapes de photolithographie, notamment utilisant un laser.

La figure 3 représente la structure obtenue après une étape de dépôt sur la totalité de la structure, c'est-à-dire sur la couche de résine 24 et sur la plaque 20 dans les ouvertures 26, d'une couche métallique 28 et d'une couche de finition 30.

La couche d'accroche 22 permet d'assurer de façon avantageuse une bonne accroche entre la couche métallique 28 et la face supérieure 21. Selon un mode de réalisation, la couche d'accroche 22 est en chrome ou en alliage de chrome. Ceci permet d'assurer de façon avantageuse une bonne accroche entre la couche métallique 28 et la face supérieure 21 en particulier lorsque la face supérieure 21 correspond à la face du revêtement 23 en carbure de tungstène.

Selon un mode de réalisation, la couche métallique 28 est en métal, par exemple en cuivre, en nickel, en argent, en or, ou en un alliage de ces métaux. De préférence, la couche métallique 28 est en cuivre. Selon un mode de réalisation, l'épaisseur de la couche métallique 28 est comprise entre 100 nm et 10 µm et est par exemple égale à environ 3 µm.

Selon un mode de réalisation, la couche de finition 30 est en un matériau conducteur qui améliore l'adhésion de pâte à braser. La couche de finition 30 est par exemple en métal, notamment en or ou en argent, et comprend éventuellement une ou des couches d'accroche et/ou une ou des couches barrière, comprenant par exemple du platine (Pt), du palladium (Pd), du nickel (Ni), du titane (Ti), du chrome (Cr), et/ou du tantale (Ta), entre le matériau de la couche métallique 28 et le matériau de la pâte à braser qui est déposée par la suite la couche de finition 30. La couche de finition 30 permet en outre d'éviter une oxydation de la couche métallique 28 dans le cas où le stockage des circuits électroacoustiques 25 et/ou le procédé d'assemblage n'est pas réalisé sous atmosphère neutre ou réductrice. Selon un mode de réalisation, l'épaisseur de la couche de finition 30 est comprise entre 10 nm et 500 nm, et est par exemple égale à environ 40 nm.

Selon un mode de réalisation, la couche métallique 28 et/ou la couche de finition 30 sont formées par un dépôt physique en phase vapeur. Selon un autre mode de réalisation, la couche métallique 28 et/ou la couche de finition 30 sont formées par galvanoplastie.

La figure 4 représente la structure obtenue après une étape de retrait, également appelée étape de décollement (en anglais lift-off), de la couche de résine 24, d'où il résulte le retrait des parties de la couche métallique 28 et de la couche de finition 30 qui recouvraient la couche de résine 24, seules restant les parties de la couche métallique 28 et de la couche de finition 30 présentes dans les ouvertures 26. Il est ainsi obtenu des UBMs 40 comprenant chacun une partie de la couche d'accroche 22, une couche métallique 42, qui correspond sensiblement à la partie de la couche métallique 28 qui était présente dans l'ouverture 26, et une couche de finition 44, qui correspond sensiblement à la partie de la couche de finition 30 qui était présente dans l'ouverture 26, la couche métallique 42 étant interposée entre la couche d'accroche 22 et la couche de finition 44 et au contact physique direct de la couche d'accroche 22 et de la couche de finition 44. La couche de finition 44 comprend une face d'extrémité 45 du côté opposé à la couche métallique 42. Les UBMs 40 sont séparées latéralement par des tranchées 47.

Selon un mode de réalisation, l'épaisseur totale de chaque UBM 40 est comprise entre 50 nm et 15 µm, par exemple égale à environ 3 µm. En vue de dessus, la face d'extrémité 45 de chaque UBM 40 peut avoir une forme circulaire, ovale, carrée, rectangulaire, etc. De préférence, en vue de dessus, la face d'extrémité 45 de chaque UBM 40 peut avoir une forme circulaire. Selon un mode de réalisation, le diamètre de cercle inscrit dans la face 45 est compris entre 20 µm et 100 µm, par exemple 60 µm. Selon un mode de réalisation, le pas des UBMs 40 est compris entre 100 µm et 500 µm.

Dans le mode de réalisation du procédé de fabrication des UBMs 40 décrits précédemment en relation avec les figures 1 à 4, le revêtement 23 en carbure de tungstène et la couche d'accroche 22 sont formés sur la face supérieure 21 de la plaque 20 avant le dépôt de la couche de résine 24, de sorte que le revêtement 23 en carbure de tungstène et la couche d'accroche 22 demeurent sur la totalité de la face supérieure 21 après l'étape de décollement de la couche de résine 24. Toutefois, il peut être souhaitable que les portions du revêtement 23 en carbure de tungstène et de la couche d'accroche 22 présentes sur la face supérieure 21 entre les UBMs 40 soient retirées. Cela peut être le cas lorsque les composants électroacoustiques 25 ne sont pas séparés à une étape ultérieure du procédé de fabrication. En effet, le revêtement 23 en carbure de tungstène étant conducteur, il pourrait alors court-circuiter des UBMs 40. Une variante du mode de réalisation du procédé de fabrication des UBMs 40 décrit précédemment en relation avec les figures 1 à 4 comprend la formation du revêtement 23 en carbure de tungstène et de la couche d'accroche 22 après la formation de la couche de résine 24 et des ouvertures 26, de sorte que le revêtement 23 en carbure de tungstène et la couche d'accroche 22 ne sont au contact de la face supérieure 21 seulement dans les ouvertures 26, et que, après l'étape de décollement de la couche de résine 24, les portions du revêtement 23 en carbure de tungstène et de la couche d'accroche 22 entre les UBMs 40 sont retirées.

Les figures 1 à 4 illustrent un mode de réalisation d'un procédé de fabrication des UBMs 40 par décollement (en anglais lift-off) qui permet notamment, de façon avantageuse, de réaliser les UBMs 40 avec sensiblement n'importe quelle forme. Toutefois, à titre de variante, les UBMs 40 peuvent être réalisés par le dépôt des couches 22, 28, et 30 sur la plaque 20 et le sciage des couches 30, 28, et 22, et éventuellement de la couche 23 et de la plaque 20 en totalité ou en partie, pour délimiter les UBMs 40.

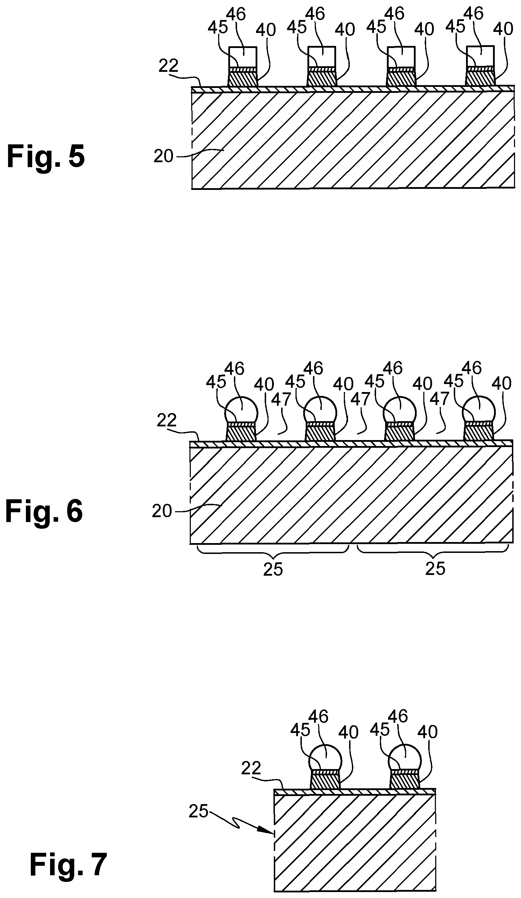

La figure 5 représente la structure obtenue après une étape de dépôt, pour chaque UBM 40, d'une bille de soudure 46 sur la face d'extrémité 45 de l'UBM 40. Les billes de soudure 46 sont composées d'une pâte à braser. La pâte comprend notamment une charge active comprenant des particules d'un matériau métallique, par exemple de l'argent, du cuivre, ou un alliage d'argent et de cuivre. La charge active peut en outre comprendre de l'or et d'autres additifs, par exemple des polymères et/ou des céramiques, ne participant pas au brasage mais facilitant les procédés de mise en oeuvre de la pâte à braser. La proportion de la charge active dans la pâte est comprise de 60 % à 97 % en masse. Selon un mode de réalisation, le dépôt des billes de soudure 46 est réalisé par impression au pochoir (en anglais stencil printing).

La figure 6 représente la structure obtenue après une étape de fusion des UBMs 40 et des billes de soudure 46 de façon que chaque bille de soudure 46 adhère à la face d'extrémité 45 sur laquelle elle repose. Selon un mode de réalisation, l'étape de fusion des UBMs 40 et des billes de soudure 46 est réalisé à une température comprise entre 130 °C et 200 °C. Les matériaux composant les composants électroacoustiques 25 sont, de façon avantageuse, adaptés à tenir la température de l'étape de fusion. La présence des tranchées 47 permet, de façon avantageuse, de limiter d'éventuels écoulements de la pâte à braser lors de la refusion des billes de soudure 46, surtout lorsque l'épaisseur des UBMs 40 est faible.

Chaque UBM 40 remplit les fonctions suivantes :
- création d'une connexion électrique entre le composant électroacoustique 25 et la bille de soudure 46 ;
- création d'une liaison mécanique entre le composant électroacoustique 25 et la bille de soudure 46 ; et
- formation d'une barrière contre la diffusion d'éléments entre le composant électroacoustique 25 et la bille de soudure 46.

La figure 7 représente la structure obtenue après une étape de découpe de la plaque 20 pour séparer les composants électroacoustiques 25, un seul composant électroacoustique 25 étant représenté en figure 7. L'étape de découpe peut être réalisée par sciage ou par découpe laser.

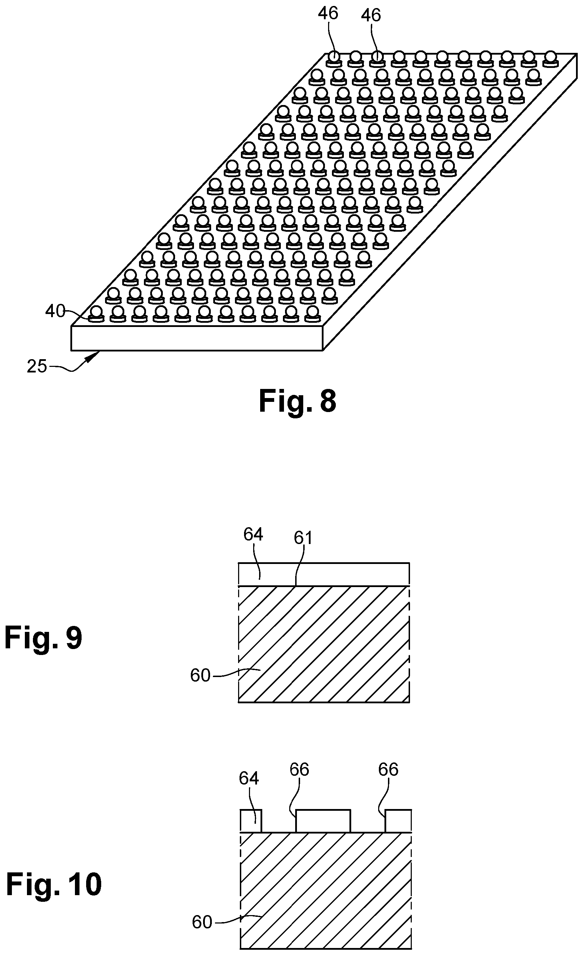

La figure 8 est une vue en perspective, partielle et schématique, du composant électroacoustique 25 avec les UBMs 40 et les billes de soudure 46.

La figure 9, la figure 10, la figure 11, et la figure 12 sont des vues en coupe, partielles et schématiques, des structures obtenues à des étapes successives d'un mode de réalisation d'un procédé de fabrication d'un dispositif électronique relatives à la fabrication de plots de connexion, également appelés UBMs, sur un circuit électronique du dispositif électronique.

La figure 9 représente la structure obtenue après une étape de formation d'une couche de résine photosensible 64 sur la face supérieure 61 d'un circuit électronique 60. Selon un mode de réalisation, l'épaisseur de la couche de résine 64 est supérieure ou égale à l'épaisseur souhaitée des UBMs. La couche de résine 64 peut avoir la même composition que la couche de résine 24. A titre d'exemple, le circuit électronique 60 correspond à un circuit intégré propre à une application (ASIC, sigle anglais pour application-specific integrated circuit), ou un circuit imprimé (PCB, sigle anglais pour printed circuit board) notamment un circuit imprimé flexible.

La figure 10 représente la structure obtenue après une étape de formation d'ouvertures 66 dans la couche de résine 64 aux emplacement souhaités des UBMs, deux ouvertures 66 étant représentées à titre d'exemple en figure 10. La formation des ouvertures 66 peut comprendre des étapes de photolithographie.

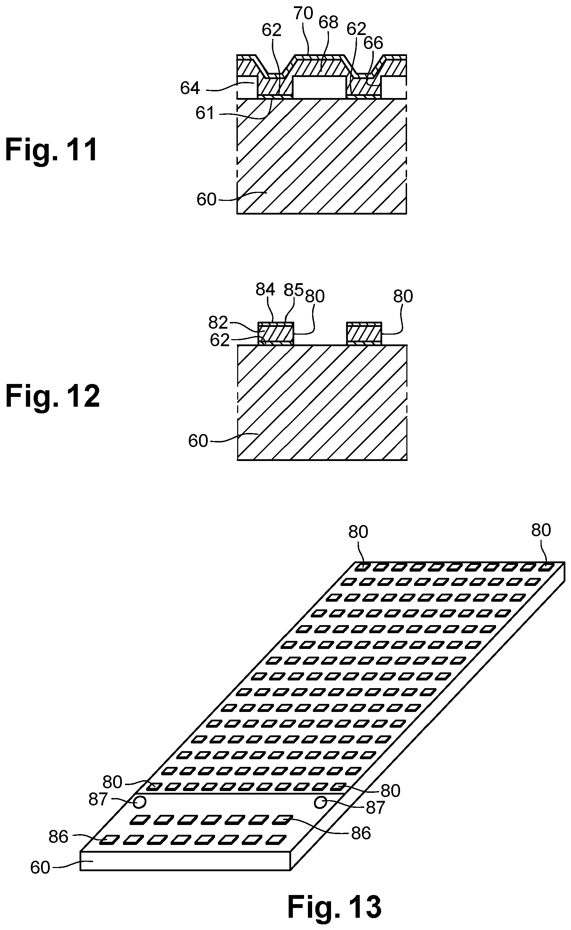

La figure 11 représente la structure obtenue après une étape de dépôt d'une couche d'accroche 62 sur la face 61 au fond de chaque ouverture 66 et une étape de dépôt sur la totalité de la structure, c'est-à-dire sur la couche de résine 64 et sur les couches d'accroche 62 dans les ouvertures 66, d'une couche métallique 68 et d'une couche de finition 70. Selon un mode de réalisation, le dépôt de la couche d'accroche 62 est précédé d'une étape de nettoyage de la face 61 dans les ouvertures 66, par exemple une étape de décapage ionique de la face 61. L'étape de décapage ionique comprend un bombardement ionique de la face 61, par exemple par des ions azote.

La couche d'accroche 62 permet d'assurer de façon avantageuse une bonne accroche entre la couche métallique 68 et la face supérieure 61. La couche d'accroche 62 peut avoir la même composition que la couche d'accroche 22 ou une composition différente de la couche d'accroche 22. Selon un mode de réalisation, la couche d'accroche 62 est en chrome ou en alliage de chrome. Selon un mode de réalisation, l'épaisseur de la couche d'accroche 62 est comprise entre 10 nm et 500 nm, et est par exemple égale à environ 40 nm.

La couche métallique 68 peut avoir la même composition que la couche métallique 28 ou une composition différente de la couche métallique 28. Selon un mode de réalisation, la couche métallique 68 est en métal, par exemple en cuivre, en nickel, en argent, en or, ou en un alliage de ces métaux. De préférence, la couche métallique 68 est en cuivre. Selon un mode de réalisation, l'épaisseur de la couche métallique 68 est comprise entre 100 nm et 10 µm et est par exemple égale à environ 3 µm.

La couche de finition 70 peut avoir la même composition que la couche de finition 30 ou une composition différente de la couche de finition 30. Selon un mode de réalisation, la couche de finition 70 est en un matériau conducteur qui améliore l'adhésion de la bille de soudure 46 lors de la refusion de la bille de soudure 46, comme cela est décrit par la suite. La couche de finition 70 est par exemple en métal, notamment en or ou en argent, et comprend éventuellement une ou des couches d'accroche et/ou une ou des couches barrière, comprenant par exemple du platine (Pt), du palladium (Pd), du nickel (Ni), du titane (Ti), du chrome (Cr), et/ou du tantale (Ta), entre le matériau de la couche métallique 68 et le matériau de la bille de soudure 46. La couche de finition 70 permet en outre d'éviter une oxydation de la couche métallique 68 dans le cas où le stockage du circuit électronique 60 et/ou le procédé d'assemblage n'est pas réalisé sous atmosphère neutre ou réductrice. Selon un mode de réalisation, l'épaisseur de la couche de finition 70 est comprise entre 10 nm et 500 nm, et est par exemple égale à environ 40 nm.

Selon un mode de réalisation, la couche d'accroche 62 et/ou la couche métallique 68 et/ou la couche de finition 70 sont formées par un dépôt physique en phase vapeur. Selon un autre mode de réalisation, la couche d'accroche 62 et/ou la couche métallique 68 et/ou la couche de finition 70 sont formées par galvanoplastie.

Selon un mode de réalisation, le dépôt de la couche d'accroche 62 est précédé d'une étape de nettoyage de la face 61, par exemple une étape de décapage ionique de la face 61. L'étape de décapage ionique comprend un bombardement ionique de la face 61, par exemple par des ions azote.

La figure 12 représente la structure obtenue après une étape de retrait de la couche de résine 64, d'où il résulte le retrait des parties de la couche métallique 68 et de la couche de finition 70 qui recouvraient la couche de résine 64, seules restant les parties de la couche métallique 68 et de la couche de finition 70 qui étaient présentes dans les ouvertures 66. Il est ainsi obtenu des UBMs 80 comprenant chacun la couche d'accroche 62, une couche métallique 82, qui correspond sensiblement à la partie de la couche métallique 68 qui était présente dans l'ouverture 66, et une couche de finition 84, qui correspond sensiblement à la partie de la couche de finition 70 qui était présente dans l'ouverture 66, la couche métallique 82 étant interposée entre la couche d'accroche 62 et la couche de finition 84 et au contact physique direct de la couche d'accroche 62 et de la couche de finition 84. La couche de finition 84 comprend une face d'extrémité 85 du côté opposé à la couche métallique 82.

Selon un mode de réalisation, l'épaisseur totale de chaque UBM 80 est comprise entre 50 nm et 15 µm, par exemple égale à environ 3 µm. En vue de dessus, la face d'extrémité 85 de chaque UBM 80 peut avoir une forme circulaire, ovale, carrée, rectangulaire, etc. De préférence, en vue de dessus, la face d'extrémité 45 de chaque UBM 40 peut avoir une forme carrée ou rectangulaire. Selon un mode de réalisation, le diamètre de cercle inscrit dans la face 85 est compris entre 20 µm et 100 µm, par exemple égal à 60 µm. En vue de dessus, la forme de la face d'extrémité 85 de chaque UBM 80 peut être différente de la forme de la face d'extrémité 45 de chaque UBM 40.

Les figures 9 à 12 illustrent un mode de réalisation d'un procédé de fabrication des UBMs 80 par décollement (en anglais lift-off) qui permet notamment, de façon avantageuse, de réaliser les UBMs 80 avec sensiblement n'importe quelle forme. Toutefois, à titre de variante, les UBMs 80 peuvent être réalisés par le dépôt des couches 62, 68, et 70 sur le circuit électronique 60 et le sciage des couches 62, 68, et 70 pour délimiter les UBMs 80.

La figure 13 est une vue en perspective, partielle et schématique, du circuit électronique 60 avec les UBMs 80. Le circuit électronique 60 peut comprendre des plots de connexion supplémentaires 86 qui peuvent être utilisés pour connecter le circuit électronique 60 à un système différent du composant électroacoustique 65, par exemple par des liaisons par fil. Le circuit électronique 60 peut en outre comprendre des mires d'alignement 87.

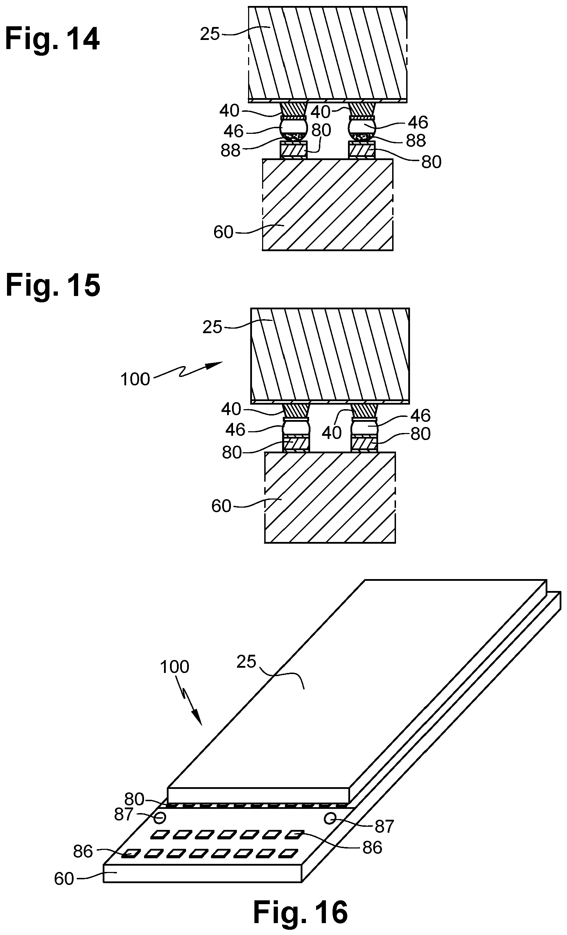

La figure 14 et la figure 15 sont des vues en coupe, partielles et schématiques, des structures obtenues à des étapes successives d'un mode de réalisation d'un procédé de fabrication d'un dispositif électronique relatives à la fixation du composant électroacoustique 25 au circuit électronique 60.

La figure 14 représente la structure obtenue après une étape d'ajout d'une couche de flux de brasage 88 sur les billes de soudure 46 et après une étape de report du composant électroacoustique 25 sur le circuit électronique 60 de façon que les billes de soudure 46 fixées aux UBMs 40, eux-mêmes fixés au composant électroacoustique 25, soient mises au contact des UBMs 80 fixées au circuit électronique 60. Le flux de brasage est un mélange de produits chimiques permettant d'assurer un bon mouillage des billes de soudure 46 sur le circuit électronique 60 lors de la refusion des billes de soudure 46 en éliminant les oxydes présents à la surface des UBMs 80, en protégeant les billes de soudure 46 et les UBMs 80 de l'oxydation pendant toute la durée de l'opération de brasage, et en baissant la tension superficielle de l'alliage d'apport composant les billes de soudure 46. L'étape d'ajout de flux de brasage 88 sur les billes de soudure 46 peut être réalisée par trempage des billes de soudure 46 dans un bain du flux de brasage. Selon un mode de réalisation, le composant électroacoustique 25 est placé sur le circuit électronique 60 par un procédé de saisie-placement (en anglais pick and place).

Selon un mode de réalisation, le composant électroacoustique 25 est déplacé vers le circuit électronique 60 par un outil de manipulation, non représenté. Selon un mode de réalisation, une pression est exercée entre le composant électroacoustique 25 et le circuit électronique 60. Selon un mode de réalisation, l'étape de placement du composant électroacoustique 25 sur le circuit électronique 60 est réalisée en utilisant les mires d'alignement 87 du circuit électronique 60. Le composant électroacoustique 25 peut ne pas comprendre de mires d'alignement, la manipulation du composant électroacoustique 25 est réalisée en utilisant les bords du composant électroacoustique 25 comme repères d'alignement. Selon un mode de réalisation, les dimensions du circuit électronique 60 sont supérieures aux dimensions du composant électroacoustique 25 de sorte que, lorsque le composant électroacoustique 25 est posé sur circuit électronique 60, aucune partie du composant électroacoustique 25 ne se trouve en porte-à-faux par rapport au circuit électronique 60.

La figure 15 représente la structure obtenue après une étape de refusion des billes de soudure 46 et des UBMs 40 et une étape de fusion des UBMs 80 pour que les billes de soudure 46 adhèrent aux UBMs 80 fixés au circuit électronique 60 et aux UBMs 40 fixés au composant électroacoustique 25. Selon un mode de réalisation, l'étape de refusion est réalisée à une température des billes de soudure 46 comprise entre 130 °C et 200 °C. Les matériaux composant les composants électroacoustiques 25 sont, de façon avantageuse, adaptés à tenir la température de l'étape de refusion. Il est ainsi obtenu un dispositif ultrasonore 100 comprenant le composant électroacoustique 25 fixé au circuit électronique 60. Le procédé peut comprendre une étape ultérieure d'introduction d'une résine entre le composant électroacoustique 25 et le circuit électronique 60 pour favoriser la tenue mécanique de l'ensemble.

La figure 16 est une vue en perspective, partielle et schématique, du dispositif ultrasonore 100 de la figure 15.

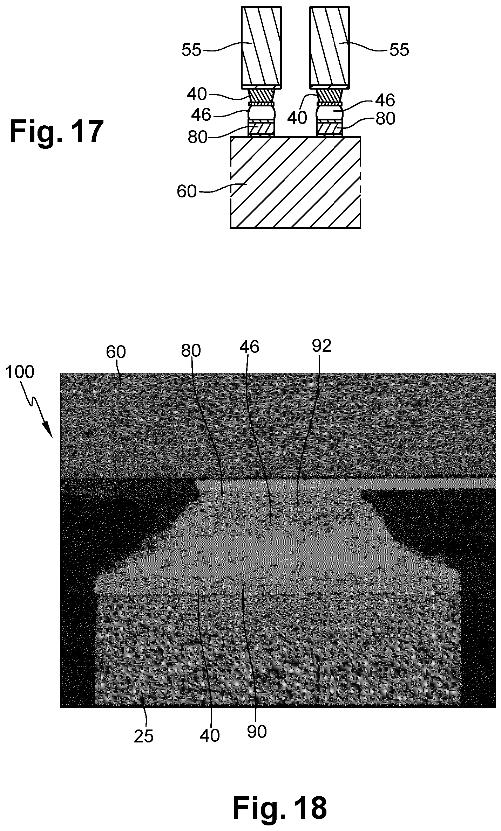

La figure 17 représente la structure obtenue après une étape ultérieure de découpe du composant électroacoustique 25 pour obtenir des composants électroacoustiques finaux 55. L'étape illustrée en figure 17 peut ne pas être présente.

La figure 18 est une image d'une coupe du dispositif ultrasonore 100 montrant un UBM 40 fixé au circuit électroacoustique 25, un UBM 80 fixé au circuit électronique 60, et une bille de soudure 46 soudée aux UBMs 40 et 80. La bille de soudure 46 est fixée à l'UBM 40 par une liaison mécanique 90 issue de deux fusions de la bille de soudure 46 et de l'UBM 40 et la bille de soudure 46 est fixée à l'UBM 80 par une liaison mécanique 92 issue de deux fusions de la bille de soudure 46 et de l'UBM 80.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Procédé de fabrication d'un dispositif ultrasonore (100) comprenant un circuit électronique (60) et un composant électroacoustique (25), le procédé comprenant les étapes suivantes :
- former des premiers plots de connexion (40) fixés à une plaque (20) comprenant un exemplaire ou des exemplaires du composant électroacoustique (25) ;
- former des billes de soudure (46) sur les premiers plots de connexion (40) ;
- faire fondre les billes de soudure (46) pour qu'elles adhèrent aux premiers plots de connexion (40) ;
- éventuellement découper la plaque (20) pour séparer les composants électroacoustiques (25) ;
- former des deuxièmes plots de connexion (80) fixés au circuit électronique (60) ;
- appliquer le composant électroacoustique (25) sur le circuit électronique (60) pour que les billes de soudure (46) viennent au contact des deuxièmes plots de connexion (80) ; et
- refaire fondre les billes de soudure (46) pour qu'elles adhèrent aux premiers plots de connexion (40) et aux deuxièmes plots de connexion (80).

2. Procédé selon la revendication 1, dans lequel chaque premier plot de connexion (40) comprend un empilement d'une couche d'accroche (22), d'une couche métallique (42) et d'une couche de finition (44), la couche métallique étant interposée entre la couche d'accroche (22) et la couche de finition (44), la couche d'accroche (22) étant au contact physique direct du composant électroacoustique (25) et de la couche métallique (42), et la couche de finition (44) étant au contact physique direct de la couche métallique (42).

3. Procédé selon la revendication 2, dans lequel la couche d'accroche (22) est en chrome ou en alliage de chrome.

4. Procédé selon la revendication 2 ou 3, dans lequel la couche métallique (42) est en cuivre.

5. Procédé selon l'une quelconque des revendications 2 à 4, dans lequel la couche de finition (44) est en or.

6. Procédé selon l'une quelconque des revendications 1 à 5, dans lequel le composant électroacoustique (25) comprend un revêtement (23) en carbure de tungstène, les premiers plots de connexion (40) étant en contact physique direct avec le revêtement (23).

7. Procédé selon la revendication 6, dans lequel la plaque (20) comprend une face (21) sur laquelle reposent les premiers plots de connexion (40), le procédé comprenant la formation du revêtement (23) en carbure de tungstène sur l'ensemble de la face (21) et le retrait des portions du revêtement (23) en carbure de tungstène sur la face (21) entre les plots de connexion (40).

8. Procédé selon l'une quelconque des revendications 1 à 7, dans lequel le circuit électronique (60) est un circuit intégré propre à une application ou un circuit imprimé.

9. Dispositif ultrasonore (100) comprenant :
- un composant électroacoustique (25) ;
- des premiers plots de connexion (40) fixés au composant électroacoustique (25) ;
- un circuit électronique (60) ;
- des deuxièmes plots de connexion (80) fixés au circuit électronique (60) ; et
- des billes de soudure (46) fixées aux premiers plots de connexion (40) par des premières liaisons issues de deux fusions des billes de soudure (46) et des premiers plots de connexion (40) et fixées aux deuxièmes plots de connexion (80) par des deuxièmes liaisons issues d'une unique fusion des deuxièmes plots de connexion (80).

10. Dispositif ultrasonore selon la revendication 9, dans lequel chaque premier plot de connexion (40) comprend un empilement d'une couche d'accroche (22), une couche métallique (42) et d'une couche de finition (44), la couche métallique étant interposée entre la couche d'accroche (22) et la couche de finition (44), la couche d'accroche (22) étant au contact physique direct du composant électroacoustique (25) et de la couche métallique (42), et la couche de finition (44) étant au contact physique direct de la couche métallique (42).

11. Dispositif ultrasonore selon la revendication 10, dans lequel la couche d'accroche (22) est en chrome ou en alliage de chrome.

12. Dispositif ultrasonore selon la revendication 10 ou 11, dans lequel la couche métallique (42) est en cuivre.

13. Dispositif ultrasonore selon l'une quelconque des revendications 10 à 12, dans lequel la couche de finition (44) est en or.

14. Dispositif ultrasonore selon l'une quelconque des revendications 9 à 13, dans lequel le composant électroacoustique (25) comprend un revêtement (23) en carbure de tungstène, les premiers plots de connexion (40) étant en contact physique direct avec le revêtement (23).

15. Dispositif ultrasonore selon l'une quelconque des revendications 9 à 14, dans lequel le circuit électronique (60) est un circuit intégré propre à une application ou un circuit imprimé.
